Europäisches Patentamt

European Patent Office

Office européen des brevets

(11) Veröffentlichungsnummer : **0 019 812**
B1

# (12) EUROPÄISCHE PATENTSCHRIFT

(45) Veröffentlichungstag der Patentschrift :
29.02.84

(21) Anmeldenummer : 80102729.3

(22) Anmeldetag : 16.05.80

(51) Int. Cl.³ : **H 03 K 17/96**, H 03 K 17/725

(54) Elektronischer Sensor-Ein/Aus-Schalter.

(30) Priorität : 31.05.79 DE 2922219

(43) Veröffentlichungstag der Anmeldung :
10.12.80 Patentblatt 80/25

(45) Bekanntmachung des Hinweises auf die Patenterteilung : 29.02.84 Patentblatt 84/09

(84) Benannte Vertragsstaaten :
FR GB IT

(56) Entgegenhaltungen :
DE-A- 2 218 285
DE-A- 2 313 942
Patents Abstracts of Japan Band 2, Nr. 129, 27.
Oktober 1978 Seite 7755E78

(73) Patentinhaber : SIEMENS AKTIENGESELLSCHAFT
Berlin und München Wittelsbacherplatz 2
D-8000 München 2 (DE)

(72) Erfinder : Hauenstein, Alfred, Ing. grad.
Terofalstrasse 3
D-8000 München 21 (DE)

Elektronischer Sensor-Ein/Aus-Schalter

Die vorliegende Erfindung betrifft einen elektronischen Sensor-Ein/Aus-Schalter für eine an einem insbesondere als Zweidraht-Leitung ausgebildeten Wechselspannungsnetz liegende Last mit einem in Reihe zur Last liegenden steuerbaren Halbleiterschalter, insbesondere Triac, der über einen als Berührungsschalter ausgebildeten Sensor zur Ein- und Ausschaltung der Last ansteuerbar ist, mit einer Stromversorgungsschaltung, die einen bei gesperrtem steuerbaren Halbleiterschalter aus der vom Wechselspannungsnetz gelieferten Ausgangswechselspannung über einen Gleichrichter aufladbaren Speicherkondensator aufweist.

Damit bei Ein/Aus-Schaltern der vorstehend genannten Art die größtmögliche Leistung an die Last abgegeben werden kann, darf durch den Schalter die Phase der aus dem Wechselspannungsnetz gelieferten Wechselspannung und des im eingeschalteten Zustand fließenden Lastwechselstroms nicht angeschnitten werden. Darüber hinaus ist dies auch aus Störgründen wichtig, da sonst aufwendige Funk-Entstör-Bauelemente vorgesehen werden müssen.

Werden Ein/Aus-Schalter über Zweidraht-Leitungen angeschlossen, so steht am Einbauort nur ein Pol des Wechselspannungsnetzes zur Verfügung. In diesen Fällen ist die Verwendung von elektronischen Ein/Aus-Schaltern problematisch, da im eingeschalteten Zustand die Restspannung am steuerbaren Halbleiterschalter so klein ist, daß sie für eine Betriebsspannungsversorgung der Elektronik nicht ausreicht.

Aus der DE-A-2 218 285 ist ein elektronischer Sensor-Ein/Aus-Schalter bekannt, der bereits die Merkmale des eingangs genannten Sensor-Ein/Aus-Schalters aufweist. Über die dabei vorhandene Stromversorgungsschaltung wird die gesamte Elektronik aus dem Wechselspannungsnetz mit einer Betriebsspannung versorgt.

Der Schalter besitzt weiterhin zwischen dem Sensorkreis und einem diesem nachgeschalteten Speicher in Form eines Flip-Flops sowie der Stromversorgungsschaltung eine UND-Schaltung und einen Nulldurchgangs-Komparator. Der Nulldurchgangskomparator vergleicht die sich nach Betätigung des Sensors in der Stromversorgungsschaltung aufbauende Spannung mit einer Referenz und schaltet nach Ansprechen des Nulldurchgangs-Komparators den steuerbaren Halbleiterschalter (Triac) über die UND-Schaltung ein.

Zwar wird damit die Gleichspannungsversorgung des Elektronikteils des Schalters sichergestellt. Der Triac schaltet jedoch nicht bereits im Nulldurchgang, sondern erst bei einem bestimmten Phasenwinkel nach dem Nulldurchgang. Es handelt sich dabei also um eine echte Phasenanschnittsteuerung. Damit ergeben sich auch bei diesem Sensor-Ein/Aus-Schalter die eingangs bereits angesprochenen Probleme.

Aus Patents Abstracts of Japan, Band 2, Nr. 129, 27.10.1978, Seite 7755 E 78 ist ein für ein Zweileiter-System ausgelegter Schalter der in Rede stehenden Art bekanntgeworden, dessen Steuerschaltung im ausgeschalteten Zustand des steuerbaren Halbleiterschalters aus der Sekundärwicklung eines Transformators mit Spannung und im eingeschalteten Zustand des steuerbaren Halbleiterschalters aus der Sekundärwicklung mit Strom versorgt wird. Dabei sind jedoch ebenfalls keine gesonderten Maßnahmen zum Schalten im jeweiligen Nulldurchgang vorgesehen.

Der vorliegenden Erfindung liegt die Aufgabe zugrunde, einen elektronischen Sensor-Ein/Aus-Schalter der in Rede stehenden Art anzugeben, mit dem eine Ansteuerung des steuerbaren Halbleiterschalters sowohl im ausgeschalteten als auch im eingeschalteten Zustand in den Nulldurchgängen der Wechselspannung bzw. in den Nulldurchgängen des im eingeschalteten Zustand fließenden Lastwechselstroms möglich ist.

Diese Aufgabe wird bei einem elektronischen Sensor-Ein/Aus-Schalter der eingangs genannten Art erfindungsgemäß durch folgende Merkmale gelöst :

Eine Steuerschaltung, durch die der steuerbare Halbleiterschalter in leitendem Zustand und damit bei eingeschalteter Last in den Nulldurchgängen eines dann fließenden Laststroms mit einem ihn im leitenden Zustand haltenden Signal und/oder im gesperrten Zustand und damit bei ausgeschalteter Last zur Einschaltung der Last im Nulldurchgang der dann am Halbleiterschalter-Kreis stehenden Ausgangswechselspannung mit einem ihn in den leitenden Zustand schaltenden Signal ansteuerbar ist, und durch eine Stromversorgungsschaltung für die Steuerschaltung mit einem eine Primärwicklung und eine Sekundärwicklung aufweisenden, in Sättigung betriebenen Stromwandler, dessen Primärwicklung in Reihe zum steuerbaren Halbleiterschalter liegt und an dessen Sekundärwicklung ein erster Gleichrichter angekoppelt ist, wobei am Ausgang dieses Gleichrichters bei leitendem steuerbarem Halbleiterschalter relativ zu einem Bezugspotentialpunkt, der gleichzeitig Bezugspotentialpunkt der Ausgangswechselspannung ist, eine Betriebsspannung abnehmbar ist, und mit einem der Reihenschaltung aus Primärwicklung des Stromwandlers und steuerbarem Halbleiterschalter parallel liegenden Zweig aus einer Reihenschaltung eines Speicher-kondensators und einem zweiten Gleichrichter, in dem im gesperrten Zustand des steuerbaren Halbleiterschalters an dem aus der Ausgangswechselspannung aufgeladenen Speicherkondensator die Betriebsspannung abnehmbar ist.

Ausgestaltungen des Erfindungsgedankens sind in Unteransprüchen gekennzeichnet.

Die Erfindung wird im folgenden anhand von in den Figuren der Zeichnung dargestellten Ausführungsbeispielen näher erläutert. Es zeigt :

Figur 1 eine erste Ausführungsform eines erfindungsgemäßen elektronischen Sensor-Ein/Aus-Schalters ;

Figur 2A bis 2H jeweils ein Signaldiagramm zur Erläuterung der Wirkungsweise des elektronischen Sensor-Ein/Aus-Schalters nach Fig. 1 ;

Figur 3 eine Ausführungsform einer Betriebsspannungsversorgungs-Schaltung für den elektronischen Sensor-Ein/Aus-Schalter nach Fig. 1 ;

Figur 4 eine Ausführungsform eines Spannungs-Nulldurchgangsdetektors für den elektronischen Sensor-Ein/Aus-Schalter nach Fig. 1 ;

Figur 5 ein Signaldiagramm zur Erläuterung der Wirkungsweise des Spannungs-Nulldurchgangsdetektors nach Fig. 4 ;

Figur 6 eine Ausführungsform eines Strom-Nulldurchgangsdetektors für den elektronischen Sensor-Ein/Aus-Schalter nach Fig. 1 ;

Figur 7A bis 7E jeweils ein Signaldiagramm zur Erläuterung der Wirkungsweise des Strom-Nulldurchgangsdetektors nach Fig. 6 ; und

Figur 8 eine weitere Ausführungsform eines erfindungsgemäßen elektronischen Sensor-Ein/Aus-Schalters.

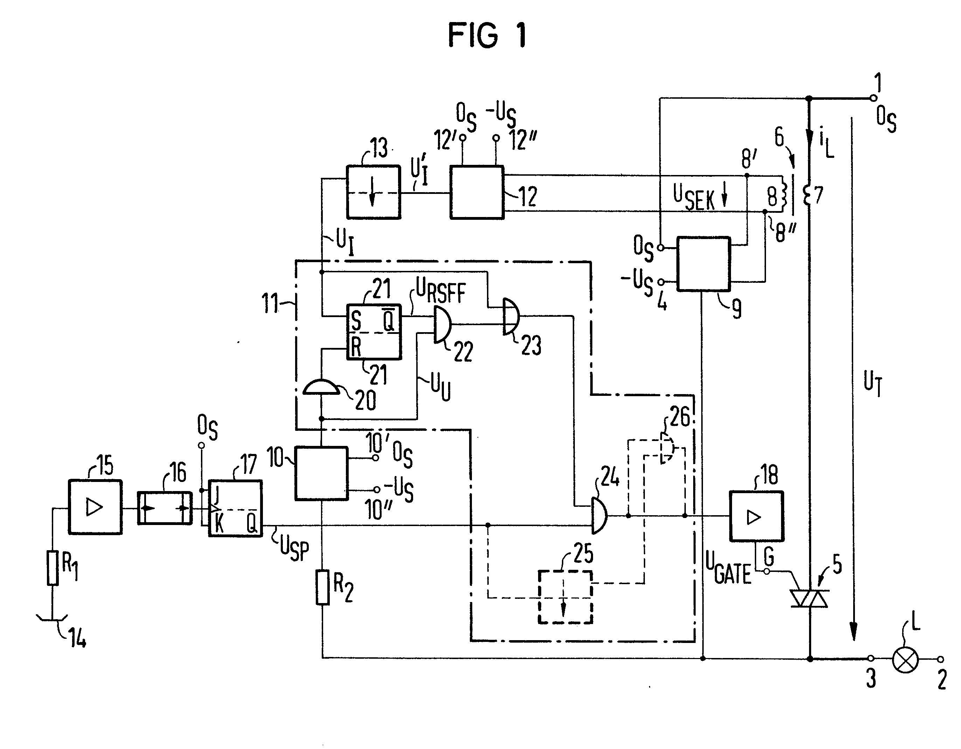

Anhand des Blockschaltbildes nach Fig. 1 sowie der Signaldiagramme nach den Fig. 2A bis 2H wird im folgenden eine erste Ausführungsform eines erfindungsgemäßen elektronischen Sensor-Ein/Aus-Schalters beschrieben.

Gemäß dem Blockschaltbild nach Fig. 1 liegt an Klemmen 1 und 2 ein als Zweidraht-Leitung ausgebildetes Wechselspannungsnetz. An diesem Wechselspannungsnetz liegt in Reihe eine Last bildende Lampe L, ein steuerbarer Halbleiterschalter in Form eines Triac 5 und eine Primärwicklung 7 eines Stromwandlers 6. Bei gesperrtem Triac 5 fällt zwischen der Klemme 1 und einer Klemme 3 an der Reihenschaltung aus Primärwicklung 7 des Stromwandlers 6 und Triac 5 eine Wechselspannung $U_T$ ab, während bei leitendem Triac 5 über die Reihenschaltung aus Primärwicklung 7 des Stromwandlers 6, Triac 5 und Lampe L ein Laststrom $i_L$ fließt. Wie anhand der Diagramme nach den Fig. 2A bis 2H im einzelnen noch erläutert wird, ist die Spannung $U_T$ auf ein Bezugspotential $O_S$ an der Klemme 1 bezogen, so daß die Klemme 3 als Ausgang des elektronischen Sensor-Ein/Aus-Schalters bezeichnet werden kann. Die Wechselspannung $U_T$ wird deshalb als Ausgangswechselspannung bezeichnet.

Wie bereits ausgeführt, ist es für die Funktion des elektronischen Sensor-Ein/Aus-Schalters wichtig, daß die Schaltvorgänge auf den Nulldurchgang der Spannung $U_T$ bzw. des Stroms $i_L$ bezogen werden. Zu diesem Zweck ist in der Schaltung nach Fig. 1 ein Spannungs-Null-durchgangsdetektor 10 sowie ein Strom-Nulldurchgangsdetektor 12 vorgesehen. Der Spannungs-Nulldurchgangsdetektor 10 ist dabei über einen Widerstand $R_2$ an die Ausgangsklemme 3 angekoppelt, während der Strom-Nulldurchgangsdetektor 12 an die Sekundärwicklung 8 des Stromwandlers 6 angekoppelt ist. Um die Stromversorgung sowohl im ausgeschalteten als auch im eingeschalteten Zustand sicherzustellen, ist erfindungsgemäß eine im folgenden noch genauer zu erläuternde Stromversorgungsschaltung 9 vorgesehen, welche eingangsseitig ebenfalls an die Sekundärwicklung 8 des Stromwandlers 6 angekoppelt ist. Diese Stromversorgungsschaltung liefert an einer Ausgangsklemme 4 in im folgenden noch genauer zu beschreibenden Weise eine Betriebsspannung $-U_S$. Eine weitere Ausgangsklemme der Stromversorgungsschaltung 9 liegt an der Klemme 1, so daß an dieser Ausgangsklemme der Stromversorgungsschaltung 9 das Bezugspotential $O_S$ zur Verfügung steht. Das Bezugspotential $O_S$ wird an einer Klemme 10' in den Spannungs-Nulldurchgangsdetektor 10 und an einer Klemme 12' in den Strom-Nulldurchgangsdetektor 12 eingegeben. Die Betriebsspannung $-U_S$ wird an einer Klemme 10″ in den Spannungs-Nulldurchgangsdetektor 10 und an einer Klemme 12″ in den Strom-Nulldurchgangsdetektor 12 eingegeben.

Zur Ansteuerung des Triac 5 an seinem Gate G mit einer Gatespannung $U_{GATE}$ werden die Ausgangssignale des Spannungs-Nulldurchgangsdetektors 10, des Strom-Nulldurchgangsdetektors 12 sowie ein Schaltsignal von einem Sensor 14 über eine Logik 11 miteinander verknüpft und über eine durch einen Verstärker gebildete Ausgangsstufe 18 in das Gate G des Triac 5 eingespeist. Dem Strom-Nulldurchgangsdetektor 12 ist dabei ein monostabiler Multivibrator 13 nachgeschaltet, über den eine vorgegebene Impulsdauer für die das Gate G des Triac 5 ansteuernden Impulse einstellbar ist.

Die Schaltsignale des Sensors 14 werden über einen Widerstand $R_I$, einen Vorverstärker 15 sowie ein Verzögerungsglied 16 auf ein Ein- und Ausschalt-JK-Flip-Flop 17 gegeben, dessen Ausgangssignal an einem Ausgang Q in die Logik 11 eingespeist wird. Das Verzögerungsglied dient zur Eliminierung von Schaltstörungen und besitzt eine Verzögerungszeit von beispielsweise etwa 0,06 sec.

Die Logik 11 enthält ein Flip-Flop 21, das an einem Setzeingang S vom Ausgangssignal $U_I$ des monostabilen Multivibrators 13 und an einem Rücksetzeingang R über einen Inverter 20 vom Ausgangssignal $U_U$ des Spannungs-Nulldurchgangsdetektors 10 angesteuert wird. Ein UND-Gatter 22 wird an einem Eingang durch ein Ausgangssignal $U_{RSFF}$ von einem komplementären Ausgang $\bar{Q}$ des Flip-Flops 21 und an einem weiteren Eingang vom Ausgangssignal des Spannungs-Nulldurchgangsdetektors 10 angesteuert. Der Ausgang des UND-Gatters 22 ist auf einen Eingang eines ODER-Gatters 23 geführt, das an einem weiteren Eingang vom Ausgangssignal $U_I$ des monostabilen Multivibrators 13 angesteuert wird. Der Ausgang des ODER-Gatters 23 ist auf einen Eingang eines weiteren UND-Gatters 24 geführt, das mit einem zweiten Eingang am Ausgang Q des Flip-Flops 17 liegt.

Der Ausgang des UND-Gatters 24 ist über eine als Verstärker ausgebildete Ausgangsstufe 18 an das Gate G des Triac 5 gekoppelt.

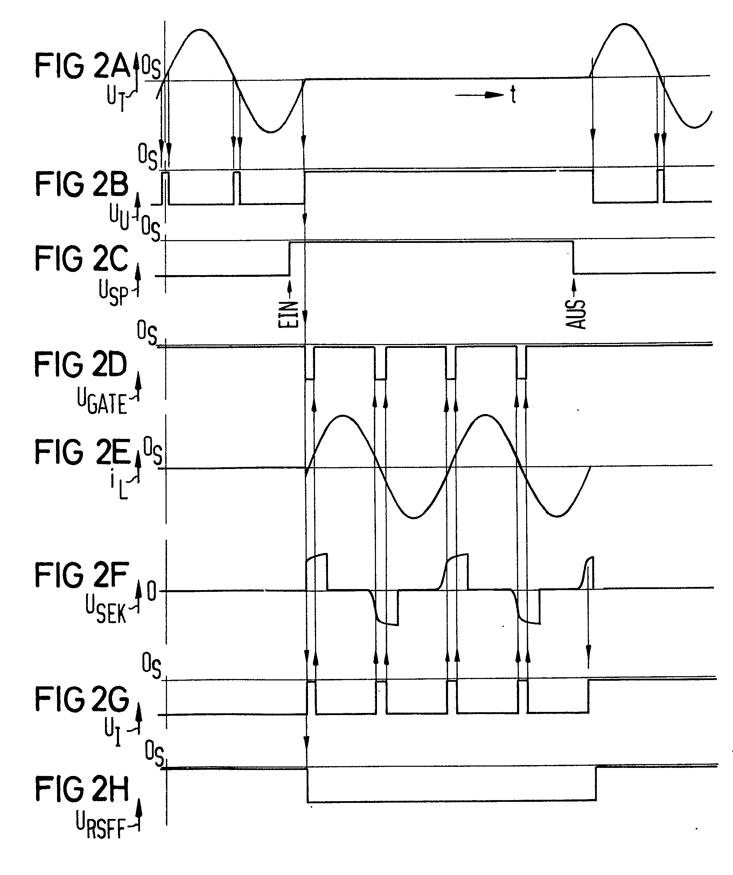

Die Wirkungsweise des vorstehend erläuterten elektronischen Sensor-Ein/Aus-Schalters ist die folgende : Es sei zunächst angenommen, daß vom Sensor 14 noch kein Einschaltsignal in die Schaltung eingegeben wird. Gemäß Fig. 2C steht dann das Flip-Flop 17 in einem Schaltzustand, in dem an seinem Ausgang Q ein Signal $U_{SP}$ mit tiefem Pegel abgegeben wird. Das UND-Gatter 24 in der Logik 11 ist daher gesperrt, so daß am Gate G des Triac 5 gemäß Fig. 2D eine auf Bezugspotential $O_S$ liegende Gate-Spannung $U_{GATE}$ steht. Der Triac 5 ist somit gesperrt. Damit fällt zwischen den Klemmen 1 und 3 gemäß Fig. 2A die Ausgangswechselspannung $U_T$ ab.

Der Spannungs-Nulldurchgangsdetektor 10 erzeugt gemäß Fig. 2B in den Nulldurchgängen der Spannung $U_T$ ein impulsförmiges Ausgangssignal $U_U$, das in den Nulldurchgängen von einem tiefen Pegel auf den Bezugspotentialpegel $O_S$ springt. Der Laststrom $i_L$ ist gemäß Fig. 2E gleich Null, so daß auch die Sekundärspannung $U_{SEK}$ an der Sekundärwicklung 8 des Stromwandlers 6 gemäß Fig. 2F gleich Null ist. Da die Ausgangsspannung $U_I'$ des Strom-Nulldurchgangsdetektors 12 auf tiefem Pegel liegt, erhält der monostabile Multivibrator 13 keine Ansteuersignale, so daß sein Ausgangssignal und damit das Ausgangssignal $U_I$ des monostabilen Multivibrators 13 gemäß Fig. 2G auf tiefem Pegel liegt. Das Flip-Flop 21 wird über das vom Inverter 20 invertierte impulsförmige Ausgangssignal $U_U$ des Spannungs-Nulldurchgangsdetektors 10 rückgesetzt, so daß an seinem Ausgang $\bar{Q}$ ein auf hohem Pegel (Bezugspotentialpegel $O_S$) liegendes Signal gemäß Fig. 2H steht.

Das UND-Gatter 22 ist daher wirksam geschaltet, so daß es das impulsförmige Ausgangssignal $U_U$ des Spannungs-Nulldurchgangsdetektors 10 auf das ODER-Gatter 23 überträgt, das seinerseits das Signal auf das UND-Gatter 24 überträgt. Da aber das Signal $U_{SP}$ am Ausgang Q des Flip-Flop 17 gemäß Fig. 2C auf tiefem Pegel liegt, bleibt das UND-Gatter 24 gesperrt, so daß das impulsförmige Ausgangssignal $U_U$ nicht auf das Gate G des Triac 5 übertragen werden kann.

Es sei nun angenommen, daß über den Sensor 14 in einem Zeitpunkt, der in Fig. 2C mit EIN bezeichnet ist, ein Einschaltsignal in die Schaltung eingegeben wird. Dieses Einschaltsignal wird in das Flip-Flop 17 übernommen, so daß das Signal $U_{SP}$ an seinem Ausgang Q auf einen hohen Pegel (Bezugspotentialpegel $O_S$) springt. Wie aus einem Vergleich der Fig. 2A und 2C zu ersehen ist, kann der Einschaltzeitpunkt in einem vom Nulldurchgang der Spannung $U_T$ verschiedenen Zeitpunkt liegen. Durch das nunmehr auf hohem Pegel liegende Ausgangssignal $U_{SP}$ des Flip-Flops 17 wird das UND-Gatter 24 aktiviert. Im nächsten auf den Einschaltzeitpunkt folgenden Nulldurchgang der Spannung $U_T$ springt das Ausgangssignal $U_U$ des Spannungs-Nulldurchgangsdetektors 10 auf einen hohen Pegel (Bezugspotentialpegel $O_S$), welcher nunmehr über das aktivierte UND-Gatter 24 auf das Gate G des Triac 5 übertragen wird, so daß dieser leitend geschaltet wird. Damit fließt gemäß Fig. 2E Laststrom $i_L$ im Kreis zwischen den Klemmen 1 und 2 gemäß Fig. 1.

Die Nulldurchgänge des nun fließenden Laststroms $i_L$ werden durch den Stromwandler 6 nach Fig. 1 in ein impulsförmiges Signal $U_{SEK}$ gemäß Fig. 2F überführt, das dadurch zustande kommt, daß der Stromwandler 6 in der Sättigung betrieben wird. Aus dieser impulsförmigen Sekundärspannung $U_{SEK}$ an der Sekundärwicklung 8 des Stromwandlers 6 erzeugen der Strom-Nulldurchgangsdetektor 12 und der nachgeschaltete monostabile Multivibrator 13 ein impulsförmiges Signal $U_I$ gemäß Fig. 2G.

Dieses Signal wird über das ODER-Gatter 23 und das durch das Einschaltsignal $U_{SP}$ gemäß Fig. 2C wirksam geschaltete UND-Gatter sowie die Ausgangsstufe 18 auf das Gate G des Triac 5 übertragen. Gleichzeitig wird das Flip-Flop 21 durch das in seinen Setzeingang eingespeiste Signal $U_I$ gesetzt, so daß das Signal $U_{RSFF}$ an seinem Ausgang $\bar{Q}$ gemäß Fig. 2H auf einen tiefen Pegel fällt und damit das UND-Gatter 22 gesperrt wird.

Da bei fließendem Laststrom $i_L$ die Spannung $U_T$ gemäß Fig. 2A zu Null wird, liefert zwar der Spannungs-Nulldurchgangsdetektor 10 im eingeschalteten Zustand des Sensor-Ein/Aus-Schalters gemäß Fig. 2B ein konstant auf hohem Pegel liegendes Ausgangssignal $U_U$. Dieses Signal wird aber wegen des gesperrten UND-Gatters 22 nicht übertragen.

Wird in einem späteren, in Fig. 2C mit AUS bezeichneten Zeitpunkt durch erneutes Betätigen des Sensors 14 der Sensor-Ein/Aus-Schalter wieder ausgeschaltet, so treten gemäß den Fig. 2A bis 2H die Signalverhältnisse wieder ein, die oben bereits für den ausgeschalteten Zustand erläutert wurden.

Handelt es sich bei der Last L gemäß Fig. 1 um eine Leuchtstofflampe, so muß bis zum vollständigen Zünden einer solchen Leuchtstofflampe eine Kompensation vorgenommen werden, da bis zum Zündzeitpunkt nicht der volle Laststrom $i_L$ fließen kann. Gemäß einer in Fig. 1 gestrichelt eingetragenen Variante ist für die Einschaltung derartiger Leuchtstofflampen in der Logik 11 eine zusätzliche Möglichkeit vorgesehen, um den Triac 5 für eine vorgegebene Anfangszeitperiode von beispielsweise einer Sekunde nach dem Einschalten kontinuierlich mit einer Gatespannung $U_{GATE}$ anzusteuern. Dazu ist an den Ausgang Q des Flip-Flops 17 ein monostabiler Multivibrator 25 angeschaltet, dessen Ausgang auf einen Eingang eines ODER-Gatters 26 geführt ist. Ein weiterer Eingang dieses ODER-Gatters 26 liegt am Ausgang des UND-Gatters 24. Der Ausgang des ODER-Gatters 26 ist über die Ausgangsstufe 18 an das Gate G des Triac 5 angekoppelt. Wird vom Sensor 14 über den Ausgang Q des Flip-Flops 17 ein Einschaltsignal geliefert, so liefert der monostabile Multi- vibrator 25 gemäß seiner für die vorgegebene Anfangszeitperiode gewählte Zeitkonstante an seinem Ausgang ein entsprechendes Signal, das über das ODER-Gatter 26 und die Ausgangsstufe 18 kontinuierlich in das Gate G des Triac 5 eingespeist wird. Damit wird der Triac 5 für die vorgegebene Anfangszeitperiode dauernd in seinem leitenden Zustand gehalten, bis die die Last L bildende Leuchtstofflampe voll gezündet hat.

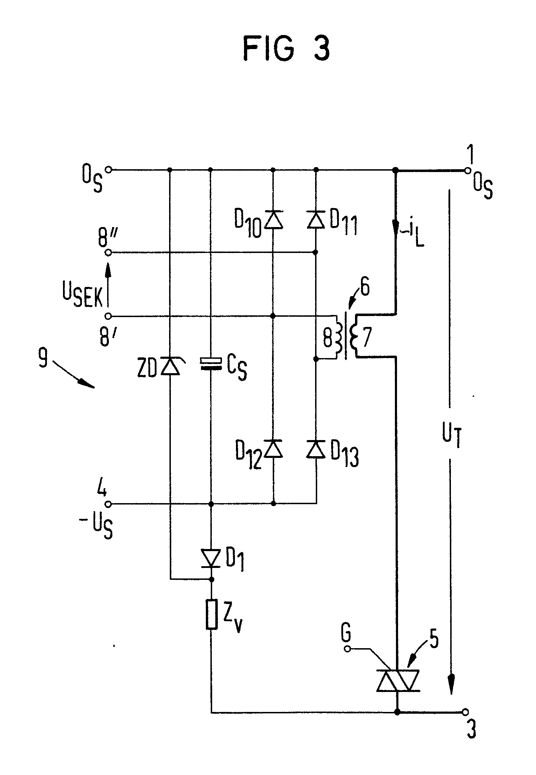

Im folgenden wird anhand von Fig. 3, in der gleiche Elemente wie in Fig. 1 mit gleichen Bezugszeichen versehen sind, die erfindungsgemäße Betriebsspannungsversorgung für die Elektronik des elektronischen Sensor-Ein/Aus-Schalters nach Fig. 1 beschrieben.

Es sei zunächst angenommen, daß der elektronische Sensor-Ein/Aus-Schalter ausgeschaltet ist, so daß zwischen den Klemmen 1 und 3 die Ausgangsspannung $U_T$ steht. Für diesen Fall ist in der Stromversorgungsschaltung 9 ein zwischen den Klemmen 1 und 3 liegender Zweig vorgesehen, welcher durch die Reihenschaltung eines Speicherkondensators $C_S$, einen Gleichrichter in Form einer Diode $D_1$ und einen Vorwiderstand $Z_V$ gebildet wird. Parallel zur Reihenschaltung aus Speicherkondensator $C_S$ und Diode $D_1$ liegt eine spannungsstabilisierende Zenerdiode ZD. Bei gesperrtem Triac 5 wird der Speicherkondensator $C_S$ aus der Ausgangsspannung $U_T$ aufgeladen, so daß an einem die Klemme 4 bildenden Verbindungspunkt zwischen dem Speicherkondensator $C_S$ und der Diode $D_1$ in Bezug auf die den Bezugspotentialpunkt $O_S$ bildende Klemme 1 die Betriebsspannung $-U_S$ abnehmbar ist.

Der Vorwiderstand $Z_V$ dient zur Strombegrenzung und kann beispielsweise durch einen rein Ohmschen Widerstand oder durch ein RC-Glied gebildet werden.

Wird der Triac 5 im Sinne der Ausführungen zu der Schaltung nach Fig. 1 in den leitenden Zustand geschaltet, so fließt der Laststrom $i_L$, wodurch an der Sekundärwicklung 8 des in Sättigung betriebenen Stromwandlers 6 die Sekundärspannung $U_{SEK}$ induziert wird. An die Sekundärwicklung 8 ist ein vorzugsweise als Vollweggleichrichter ausgebildeter Gleichrichter angeschaltet, welcher durch Dioden $D_{10}$, $D_{11}$, $D_{12}$ und $D_{13}$ gebildet wird. Die Ausgangsseite dieses Gleichrichters liegt an den Klemmen 1 und 4. Der Gleichrichter richtet die Sekundärspannung $U_{SEK}$ gleich und erzeugt damit im eingeschalteten Zustand des elektronischen Sensor-Ein/Aus-Schalters an der Klemme 4 bezogen auf die den Bezugspotentialpunkt $O_S$ bildende Klemme 1 die Betriebsspannung $-U_S$.

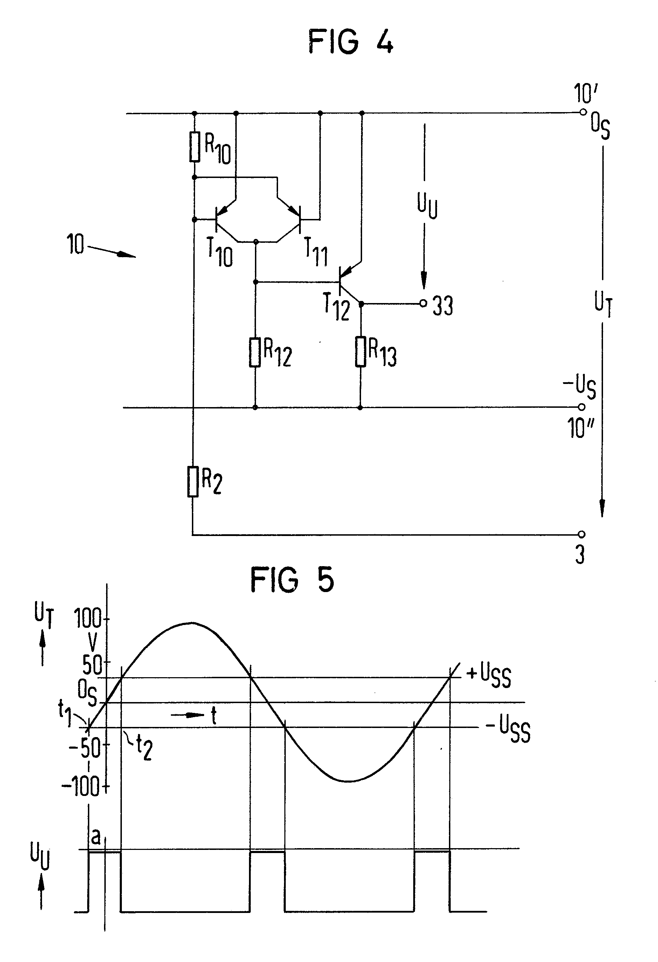

Im folgenden wird anhand von Fig. 4 eine Ausführungsform des Spannungs-Nulldurchgangsdetektors 10 nach Fig. 1 beschrieben.

Zwischen den Klemmen 10' und 3 dieses Spannungs-Nulldurchgangsdetektors steht die bereits anhand der Fig. 1 und 2A bis 2H bereits erläuterte Ausgangswechselspannung $U_T$. An der Klemme 10'' wird die Betriebsspannung $-U_S$ eingespeist. Der Spannungs-Nulldurchgangsdetektor enthält zwei Transistoren $T_{10}$ und $T_{11}$, die mit ihren Kollektoren direkt zusammengeschaltet und über einen Arbeitswiderstand $R_{12}$ an der Betriebsspannung $-U_S$ liegen. Der Emitter des Transistors $T_{10}$ und die Basis des Transistors $T_{11}$ sind direkt an die das Bezugspotential $O_S$ führende Klemme 10' angeschaltet. Die Basis des Transistors $T_{10}$ und der Emitter des Transistors $T_{11}$ liegen am Abgriff eines Spannungsteilers, der aus einem Widerstand $R_{10}$ und den bereits anhand von Fig. 1 erwähnten Widerstand $R_2$ gebildet wird. Dieser Spannungsteiler liegt zwischen der Klemme 10' und der Ausgangsklemme 3.

Ein Ausgangstransistor $T_{12}$ liegt mit seiner Basis am Verbindungspunkt der Kollektoren der Transistoren $T_{10}$ und $T_{11}$ sowie des Arbeitswiderstandes $R_{12}$. Der Emitter des Transistors $T_{12}$ liegt direkt an der Bezugspotential $O_S$ führenden Klemme 10', während sein Kollektor über einen Arbeitswiderstand $R_{13}$ an der die Betriebsspannung $-U_S$ führenden Klemme 10'' liegt. Der Verbindungspunkt des Kollektors des Transistors $T_{12}$ und des Arbeitswiderstandes $R_{13}$ bildet einen Ausgang 33 des Spannungs-Nulldurchgangsdetektors, wobei zwischen der Klemme 10' und diesem Ausgang 33 das impulsförmige Ausgangssignal $U_U$ des Spannungs-Nulldurchgangsdetektors 10 abnehmbar ist.

Die Wirkungsweise dieser Ausführungsform des Spannungs-Nulldurchgangsdetektors wird anhand des Diagramms nach Fig. 5 erläutert, das in seinem oberen Teil die sinusförmig verlaufende Ausgangswechselspannung $U_T$ an der Ausgangsklemme 3 bezogen auf das Bezugspotential $O_S$ an der Klemme 10' als Funktion der Zeit und im unteren Teil das impulsförmige Ausgangssignal $U_U$ als Funktion der Zeit zeigt.

Es sei zunächst angenommen, daß die Ausgangsspannung $U_T$ in ihrer negativen Halbwelle größer als eine Schwellspannung $-U_{SS}$ ist. Für diese Werte der Ausgangsspannung $U_T$ ist der Transistor $T_{10}$ voll durchgesteuert, so daß sein Kollektor praktisch auf Bezugspotential $O_S$ an der Klemme 10' liegt, während der Transistor $T_{11}$ gesperrt ist, weil sein Emitter auf dem gleiche negativen Potential wie die Basis des Transistors $T_{10}$ liegt. Da die Basis des Transistors $T_{12}$ über den voll durchgesteuerten Transistor $T_{10}$ praktisch aus Bezugspotential $O_S$ an der Klemme 10' liegt, ist der Transistor $T_{12}$ gesperrt, so daß an ihm praktisch die gesamte Betriebsspannung $-U_S$ abfällt. Damit liegt das Ausgangssignal $U_U$ gemäß dem unteren Diagramm nach Fig. 5 auf einem negativen (tiefen) Pegel.

Erreicht nun die Ausgangsspannung $U_T$ gemäß dem oberen Diagramm nach Fig. 5 in einem Zeitpunkt $t_1$ in ihrer negativen Halbwelle den negativen Schwellwert $-U_{SS}$, so wird der Transistor $T_{10}$ gesperrt, wobei auch der Transistor $T_{11}$ noch gesperrt bleibt, weil sein Emitter relativ zum Bezugspotential $O_S$ an der Klemme 10' noch auf negativerem Potential liegt. Der Transistor $T_{12}$ kann nunmehr über seine Emitter-Basis-Strecke und den Widerstand $R_{12}$ Strom ziehen, so daß er voll durchgesteuert wird. Sein Kollektorpotential wird damit gleich dem Bezugspotential $O_S$ an der Klemme 10', so daß das Ausgangssignal $U_U$ gemäß dem unteren Diagramm nach Fig. 4 auf den Bezugspotentialpegel $O_S$ springt.

Erreicht die Spannung $U_T$ in ihrer positiven Halbwelle in einem Zeitpunkt $t_2$ einen positiven Schwellwert $+U_{SS}$, so wird der Emitter des Transistors $T_{11}$ positiver als die an Bezugspotential $O_S$ an der Klemme 10' liegende Basis, so daß der Transistor $T_{11}$ durchgesteuert wird. Der Transistor $T_{10}$ bleibt gesperrt, weil seine Basis auf positiverem Potential als sein Emitter liegt. Aufgrund des durchgeschalteten Transistors $T_{11}$ wird nunmehr die Basis des Transistors $T_{12}$ wieder auf Bezugspotential $O_S$ gezogen, so daß dieser Transistor wieder gesperrt und die Ausgangsspannung $U_U$ wiederum auf den negativen (tiefen) Pegel springt.

Der Vorgang wiederholt sich entsprechend in allen Nulldurchgängen der Ausgangsspannung $U_T$.

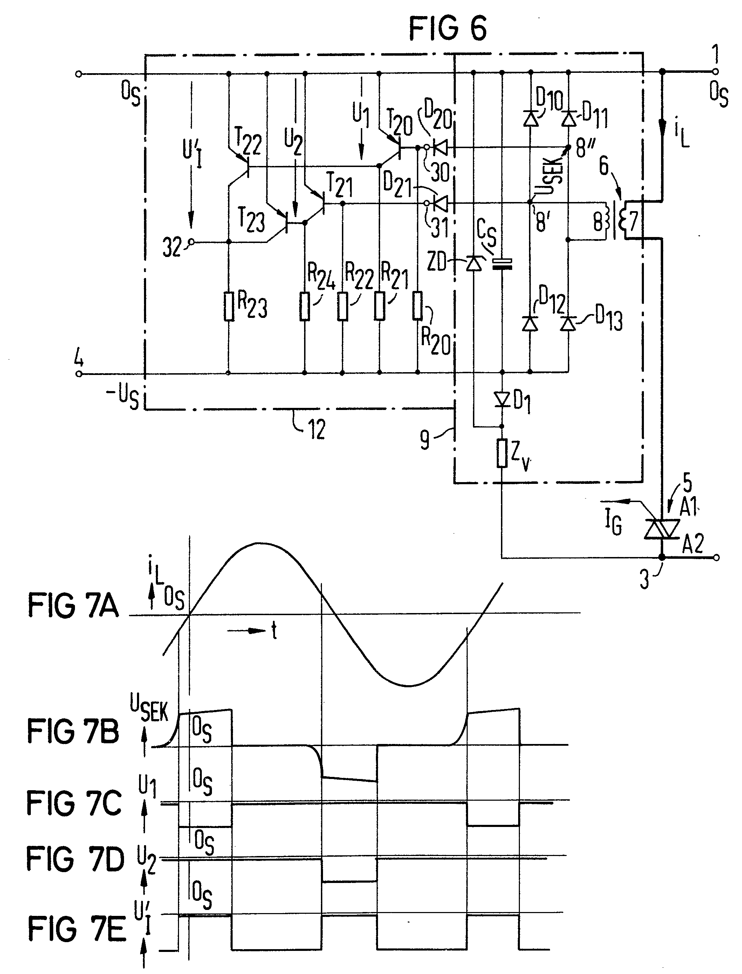

Im folgenden wird anhand der Fig. 6 und 7A bis 7E eine Ausführungsform des Strom-Nulldurchgangsdetektors 12 nach Fig. 1 beschrieben. Für die Erläuterung der Wirkungsweise dieses Strom-Nulldurchgangsdetektors sind in Fig. 6 der Lastkreis mit Triac 5 und Stromwandler 6 sowie die Stromversorgungsschaltung 9 gemäß Fig. 3 noch einmal mit dargestellt.

Der Strom-Nulldurchgangsdetektor liegt über Eingangsdioden $D_{20}$ und $D_{21}$ an der Sekundärspannung $U_{SEK}$ des Stromwandlers 8 (Klemmen 8' und 8''). Diese Dioden $D_{20}$ und $D_{21}$ sind auf die Basis eines Transistors $T_{20}$ bzw. $T_{21}$ geführt, wobei die Basen dieser Transistoren weiterhin über einen Widerstand $R_{20}$ bzw. $R_{22}$ an der Betriebsspannung $-U_S$ (Klemme 4) liegen. Die Emitter dieser beiden Transistoren $T_{20}$ und $T_{21}$ liegen direkt an Bezugspotential $O_S$ (Klemme 1), während ihre Kollektoren über einen Widerstand $R_{21}$ bzw. $R_{24}$ an der Betriebsspannung $-U_S$ (Klemme 4) liegen. Den Transistoren $T_{20}$ und $T_{21}$ ist jeweils ein Transistor $T_{22}$ bzw. $T_{23}$ nachgeschaltet, deren Basis jeweils am Kollektor des Transistors $T_{20}$ bzw. des Transistors $T_{21}$ liegt. Die Emitter der Transistoren $T_{22}$ und $T_{23}$ liegen ebenfalls direkt an Bezugspotential $O_S$ (Klemme 1), während ihre Kollektoren über einen Widerstand $R_{23}$ an der Betriebsspannung $-U_S$ (Klemme 4) liegen. An einem Ausgang 32 des Strom-Nulldurchgangsdetektors 12 ist in Bezug auf die Klemme 1 (Bezugspotential $O_S$) das Ausgangssignal $U_l$ abnehmbar.

Die Wirkungsweise des vorstehend beschriebenen Strom-Nulldurchgangsdetektors wird in Verbindung mit den Signaldiagrammen nach Fig. 7A bis 7E beschrieben. Es sei zunächst die positive Halbwelle des Laststroms $i_L$ nach Fig. 7A betrachtet. Dabei steht dann an der Sekundärwicklung 8 des Stromwandlers 6 die Sekundärspannung $U_{SEK}$ mit einer Polarität, bei der die Klemme 8' positiv gegenüber der Klemme 8'' ist.

Da der Stromwandler 6 in Sättigung betrieben wird, hat die Sekundärspannung $U_{SEK}$ einen Verlauf gemäß Fig. 7B, wobei in der positiven Halbwelle des Laststroms $i_L$ ein positiver, den Nulldurchgang des Laststroms kennzeichnender Spannungsimpuls entsteht.

Die Wirkungsweise des vorstehend beschriebenen Strom-Nulldurchgangsdetektors wird in Verbindung mit den Signaldiagrammen nach den Fig. 7A bis 7E beschrieben. Da der Stromwandler 6 in Sättigung betrieben wird, entsteht an seiner Sekundärwicklung 8 gemäß Fig. 7B eine impulsförmige Sekundärspannung $U_{SEK}$ mit Impulsen in den Nulldurchgängen des Laststroms $i_L$ gemäß Fig. 7A. Dies ergibt sich daraus, daß die magnetische Induktion im Kern des Stromwandlers als Funktion des Magnetfeldes in einem engen Bereich um den Nullpunkt eine große Steigung besitzt und außerhalb dieses engen Bereiches in die Sättigung gelangt.

Es sei nun zunächst der Bereich betrachtet, in dem die Sekundärspannung $U_{SEK}$ zwischen zwei Impulsen gemäß Fig. 7B auf Bezugspotential $O_S$ liegt, d. h., die Spannung zwischen den Klemmen 8' und 8'' in Fig. 6 ist gleich Null. Daher können die Transistoren $T_{20}$ und $T_{21}$ im Strom-Nulldurchgangsdetektor nach Fig. 6 über ihre Basis-Emitter-Strecken und den Widerstand $R_{20}$ bzw. $R_{22}$ Strom ziehen, wodurch sie in den leitenden Zustand geschaltet werden. Die Basen der Transistoren $T_{22}$ und $T_{23}$ liegen dann praktisch auf Bezugspotential $O_S$ an der Klemme 1, so daß diese Transistoren gesperrt sind. Spannungen $U_1$ und $U_2$ an den Transistoren $T_{20}$ und $T_{21}$ sind daher gleich dem Bezugspotential $O_S$, während das Ausgangssignal $U_l'$ des Strom-Nulldurchgangsdetektors wegen der gesperrten Transistoren $T_{22}$ und $T_{23}$ gleich der Betriebsspannung $-U_S$ ist, d. h., dieses Ausgangssignal liegt gemäß Fig. 7E auf tiefem Pegel.

Im ersten, in Fig. 7A dargestellten Nulldurchgang des Laststromes $i_L$ tritt nun gemäß Fig. 7B ein positiver Impuls der Sekundärspannung $U_{SEK}$ auf. Da der Laststrom $i_L$ auf Bezugspotential $O_S$ an der Klemme 1 bezogen ist, wird damit das positive Potential an der Klemme 8'' über die Diode $D_{20}$ auf die Basis des Transistors $T_{20}$ übertragen, so daß dieser gesperrt wird. Damit springt die Spannung $U_1$ am Transistor $T_{20}$ gemäß Fig. 7C praktisch auf den Wert der Betriebsspannung $-U_S$. Nunmehr kann der Transistor $T_{22}$ über seine Emitter-Basis-Strecke und den Widerstand $R_{21}$ Strom ziehen, so daß er in den leitenden Zustand geschaltet wird. Damit springt das Ausgangssignal $U_l'$ gemäß Fig. 7E auf das Bezugspotential $O_S$.

Im nächsten Nulldurchgang des Laststroms $i_L$ gemäß Fig. 7A kehrt sich die Polarität des Impulses der Sekundärspannung $U_{SEK}$ gemäß Fig. 7B um. Nunmehr wird das positive Potential an der Klemme 8' über die Diode $D_{21}$ auf die Basis des Transistors $T_{21}$ übertragen, so daß dieser Transistor sperrt und die Spannung $U_2$ gemäß Fig. 7D praktisch auf die Betriebsspannung $-U_S$ springt. Damit kann der Transistor

$T_{23}$ über seine Emitter-Basis-Strecke und den Widerstand $R_{24}$ Strom ziehen, so daß er durchgeschaltet wird und das Ausgangssignal $U_i'$ gemäß Fig. 7E wiederum auf Bezugspotential $O_S$ springt.

Der Vorgang wiederholt sich entsprechend für alle Nulldurchgänge des Laststroms $i_L$.

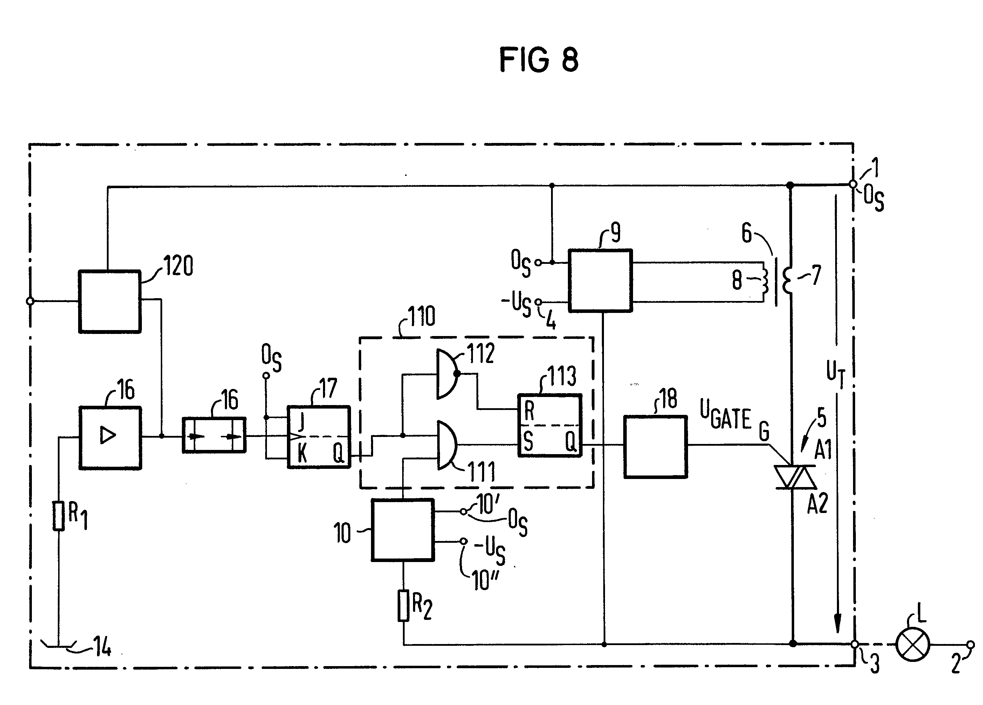

Fig. 8, in der gleiche Elemente wie in Fig. 1 mit gleichen Bezugszeichen versehen sind, zeigt eine weitere Ausführungsform des erfindungsgemäßen Sensor-Ein/Aus-Schalters gemäß der Erfindung. Hinsichtlich der bereits anhand von Fig. 1 erläuterten Komponenten des Sensor-Ein/Aus-Schalters wird auf die Ausführungen zu Fig. 1 verwiesen.

Bei der Ausführungsform nach Fig. 8 wird das Gate G des Triac 5 mit einem Dauersignal $U_{GATE}$ angesteuert. Zu diesem Zweck enthält eine Logik 110 ein UND-Gatter 111 das mit einem Eingang an den Ausgang des bereits erläuterten Spannungs-Nulldurchgangsdetektors 10 und mit einem weiteren Eingang an das bereits erläuterte Flip-Flop 17 angeschaltet ist. Der Ausgang des Flip-Flops 17 ist weiterhin über einen Inverter 112 an einen Rücksetzeingang R eines Flip-Flops 113 angekoppelt, während der Ausgang des UND-Gatters 111 an einen Setzeingang S des Flip-Flops 113 angekoppelt ist. Ein Ausgang Q des Flip-Flops 113 ist über die bereits erläuterte Ausgangsstufe 18 an das Gate G des Triacs 5 angekoppelt.

Wird der Sensor 14 zur Einschaltung betätigt, so wird das Flip-Flop 17 gesetzt und liefert an seinem Ausgang Q ein Ausgangssignal, wodurch das UND-Gatter 111 wirksam geschaltet wird. Im nächsten Nulldurchgang der Spannung $U_T$ zwischen den Klemmen 1 und 3 liefert der Spannungs-Nulldurchgangsdetektor 10 in der anhand der Fig. 1, 3 und 4 erläuterten Weise ein impulsförmiges Ausgangssignal, das über das UND-Gatter 111 auf den Setzeingang S des Flip-Flops 113 übertragen wird, wodurch dieses Flip-Flop gesetzt wird. Das dann an seinem Ausgang Q stehende Ausgangssignal wird über die Ausgangsstufe auf das Gate G des Triacs 5 übertragen. Dieser Schaltzustand wird so lange kontinuierlich aufrechterhalten, bis der Sensor 14 zur Ausschaltung der Last L erneut betätigt wird. Dabei wird dann das Flip-Flop 17 rückgesetzt, so daß sein Ausgang Q auf einen tiefen Pegel fällt. Dieser tiefe Pegel wird durch den Inverter 112 invertiert, so daß das Flip-Flop 113 rückgesetzt wird, d. h., der Ausgang Q dieses Flip-Flops fällt auf einen tiefen Pegel, so daß das Steuersignal $U_{GATE}$ am Gate G des Triacs 5 verschwindet, wodurch der Triac gesperrt und die Last ausgeschaltet wird.

Soll der Sensor-Ein/Aus-Schalter auch noch von einer anderen Stelle aus (Nebenstelle) geschaltet werden können, so kann ein Nebenstelleneingang 120 vorgesehen werden, welcher vor dem Verzögerungsglied 16 in den Gesamtkreis eingeschaltet ist. Über einen dem Sensor 14 entsprechenden Sensor kann der Ein/Aus-Schalter dann auch noch von einer anderen Stelle ein- und ausgeschaltet werden.

## Ansprüche

1. Elektronischer Sensor-Ein/Aus-Schalter für eine an einem insbesondere als Zweidraht-Leitung ausgebildeten Wechselspannungsnetz liegende Last mit einem in Reihe zur Last liegenden steuerbaren Halbleiterschalter, insbesondere Triac, der über einen als Berührungsschalter ausgebildeten Sensor zur Ein- und Ausschaltung der Last ansteuerbar ist, mit einer Stromversorgungsschaltung, die einen bei gesperrtem steuerbaren Halbleiterschalter aus der vom Wechselspannungsnetz gelieferten Ausgangswechselspannung über einen Gleichrichter aufladbaren Speicherkondensator aufweist, gekennzeichnet durch eine Steuerschaltung (10, 11, 12 ; 10, 110), durch die der steuerbare Halbleiterschalter (5) in leitendem Zustand und damit bei eingeschalteter Last (L) in den Nulldurchgängen eines dann fließenden Laststroms ($i_L$) mit einem ihn im leitenden Zustand haltenden Signal und/oder im gesperrten Zustand und damit bei ausgeschalteter Last (L) zur Einschaltung der Last (L) im Nulldurchgang der dann am Halbleiterschalter-Kreis stehenden Ausgangswechselspannung ($U_T$) mit einem ihn in den leitenden Zustand schaltenden Signal ansteuerbar ist, und durch eine Stromversorgungsschaltung (9) für die Steuerschaltung (10, 11, 12 ; 10, 110) mit einem eine Primärwicklung (7) und eine Sekundärwicklung (8) aufweisenden, in Sättigung betriebenen Stromwandler (6), dessen Primärwicklung (7) in Reihe zum steuerbaren Halbleiterschalter (5) liegt und an dessen Sekundärwicklung (8) ein erster Gleichrichter ($D_{10}$ bis $D_{13}$) angekoppelt ist, wobei am Ausgang dieses Gleichrichters ($D_{10}$ bis $D_{13}$) bei leitendem steuerbarem Halbleiterschalter (5) relativ zu einem Bezugspotentialpunkt ($O_S$), der gleichzeitig Bezugspotentialpunkt der Ausgangswechselspannung ($U_T$) ist, eine Betriebsspannung ($-U_S$) abnehmbar ist, und mit einem der Reihenschaltung aus Primärwicklung (7) des Stromwandlers (6) und steuerbarem Halbleiterschalter (5) parallel liegenden Zweig aus einer Reihenschaltung eines Speicherkondensators ($C_S$) und einem zweiten Gleichrichter ($D_1$), in dem im gesperrten Zustand des steuerbaren Halbleiterschalters (5) an dem aus der Ausgangswechselspannung ($U_T$) aufgeladenen Speicherkondensator ($C_S$) die Betriebsspannung ($-U_S$) abnehmbar ist.

2. Elektronischer Sensor-Ein/Aus-Schalter nach Anspruch 1, dadurch gekennzeichnet, daß der erste Gleichrichter ($D_{10}$ bis $D_{13}$) ein Vollweggleichrichter ist.

3. Elektronischer Sensor-Ein/Aus-Schalter nach Anspruch 1 und 2, dadurch gekennzeichnet, daß der Reihenschaltung aus Speicherkondensator ($C_S$) und zweitem Gleichrichter ($D_1$) eine Zener-Diode (ZD) parallelgeschaltet ist.

4. Elektronischer Sensor-Ein/Aus-Schalter nach einem der Ansprüche 1 bis 3, dadurch gekennzeichnet, daß dem Zweig aus Speicherkondensator ($C_S$) und zweitem Gleichrichter ($D_1$) ein Vorwiderstand ($Z_V$) vorgeschaltet ist.

5. Elektronischer Sensor-Ein/Aus-Schalter nach einem der Ansprüche 1 bis 4, dadurch gekennzeichnet, daß die Steuerschaltung (10, 11, 12)

einen Spannungs-Nulldurchgangsdetektor (10) welcher bei gesperrtem steuerbarem Halbleiterschalter (5) und damit ausgeschalteter Last (L) als Funktion der Nulldurchgänge der Ausgangswechselspannung ($U_T$) ein impulsförmiges Ausgangssignal ($U_U$) abgibt, eine durch ein Einschaltsignal vom Sensor (14) und vom impulsförmigen Ausgangssignal ($U_U$) des Spannungs-Nulldurchgangsdetektors (10) wirksam geschaltete Logik (11) zur Einspeisung des impulsförmigen Ausgangssignals des Spannungs-Nulldurchgangsdetektors (10) in eine Steuerelektrode (G) des steuerbaren Halbleiterschalters (5), und einen an eine Sekundärwicklung (8) des Stromwandlers (6) angekoppelten Strom-Nulldurchgangsdetektor (12), welcher die Sekundärspannung ($U_{SEK}$) des Stromwandlers (6) in ein impulsförmiges Ausgangssignal ($U_I'$) überführt, enthält, wobei die Logik (11) den Spannungs-Nulldurchgangsdetektor (10) bei leitendem, steuerbarem Halbleiterschalter (5) von der Steuerelektrode (G) des steuerbaren Halbleiterschalters (5) abkoppelt und das impulsförmige Ausgangssignal ($U_I'$) des Strom-Nulldurchgangsdetektors (12) auf die Steuerelektrode (G) des steuerbaren Halbleiterschalters (5) koppelt.

6. Elektronischer Sensor-Ein/Aus-Schalter nach einem der Ansprüche 1 bis 5, gekennzeichnet durch einen Spannungs-Nulldurchgangsdetektor (10) folgender Ausbildung :

einen ersten Transistor ($T_{10}$), der mit seinem Emitter am Bezugspotentialpunkt ($O_S$) der Ausgangswechselspannung ($U_T$), mit seinem Kollektor über einen Arbeitswiderstand ($R_{12}$) an der Betriebsspannung (-$U_S$) und mit seiner Basis am Abgriff eines an der Ausgangswechselspannung ($U_T$) liegenden Spannungsteilers ($R_{10}$, $R_2$) liegt,

einen zweiten Transistor ($T_{11}$), der mit seinem Emitter am Abgriff des Spannungsteilers ($R_{10}$, $R_2$), mit seinem Kollektor über den Arbeitswiderstand ($R_{12}$) an der Betriebsspannung (-$U_S$) und mit seiner Basis am Bezugspotentialpunkt ($O_S$) der Ausgangswechselspannung ($U_T$) liegt,

und einen dritten Transistor ($T_{12}$), der mit seinem Emitter am Bezugspotentialpunkt ($O_S$) der Ausgangswechselspannung ($U_T$), mit seinem Kollektor über einen weiteren Arbeitswiderstand ($R_{13}$) an der Betriebsspannung (-$U_S$) und mit seiner Basis am Verbindungspunkt der Kollektoren des ersten und zweiten Transistors ($T_{10}$, $T_{11}$) und deren Arbeitswiderstand ($R_{12}$) liegt, wobei der Spannungsteiler ($R_{10}$, $R_2$) so dimensioniert ist, daß der erste und zweite Transistor ($T_{10}$, $T_{11}$) bei einem vorgegebenen negativen bzw. positiven Wert im Bereich des Nulldurchgangs der Ausgangswechselspannung ($U_T$) durchgeschaltet werden und wobei das impulsförmige Ausgangssignal ($U_U$) zwischen dem Bezugspotentialpunkt ($O_S$) der Ausgangswechselspannung ($U_T$) und dem Kollektor des dritten Transistors

($T_{12}$) abnehmbar ist.

7. Elektronischer Sensor-Ein/Aus-Schalter nach einem der Ansprüche 1 bis 6, gekennzeichnet durch einen Strom-Nulldurchgangsdetektor (12) folgender Ausbildung :

einen ersten Eingangs-Transistor ($T_{20}$), dessen Basis eine Eingangsklemme (30) bildet und über einen Widerstand ($R_{20}$) an der Betriebsspannung (-$U_S$) liegt, dessen Emitter am Bezugspotentialpunkt ($O_S$) der Ausgangswechselspannung ($U_T$) und dessen Kollektor über einen Arbeitswiderstand ($R_{21}$) an der Betriebsspannung (-$U_S$) liegt, einen zweiten Eingangs-Transistor ($T_{21}$) dessen Basis eine weitere Eingangsklemme (31) bildet und über einen Widerstand ($R_{22}$) an der Betriebsspannung (-$U_S$) liegt, dessen Emitter am Bezugspotentialpunkt ($O_S$) der Ausgangswechselspannung ($U_T$) und dessen Kollektor über einen Arbeitswiderstand $R_{24}$ an der Betriebsspannung (-$U_S$) liegt, und jeweils einen dem ersten bzw. zweiten Eingangs-Transistor ($T_{20}$ bzw. $T_{21}$) nachgeschalteten Ausgangs-Transistor ($T_{22}$ bzw. $T_{23}$), deren Basis am Kollektor des entsprechenden Eingangstransistors ($T_{20}$ bzw. $T_{21}$), deren Emitter am Bezugspotentialpunkt ($O_S$) der Ausgangswechselspannung ($U_T$) und deren Kollektoren gemeinsam über einen Arbeitswiderstand ($R_{23}$) an der Betriebsspannung (-$U_S$) liegen, wobei das impulsförmige Ausgangssignal ($U_I'$) zwischen dem Bezugspotentialpunkt (-$O_S$) der Ausgangswechselspannung ($U_T$) und den Kollektoren der Ausgangs-Transistoren ($T_{22}$, $T_{23}$) abnehmbar ist.

8. Elektronischer Sensor-Ein/Aus-Schalter nach einem der Ansprüche 5 bis 7, dadurch gekennzeichnet, daß der Strom-Nulldurchgangsdetektor (12) mit seinen Eingangsklemmen (30, 31) über jeweils eine Diode ($D_{20}$, $D_{21}$) an die Sekundärwicklung (8) des Stromwandlers (6) angekoppelt ist.

9. Elektronischer Sensor-Ein/Aus-Schalter nach einem der Ansprüche 5 bis 8, dadurch gekennzeichnet, daß der Strom-Nulldurchgangsdetektor (12) zur Einstellung einer vorgegebenen Impulsdauer seines impulsförmigen Ausgangssignals ($U_I'$) über einen monostabilen Multivibrator (13) an die Logik (11) angekoppelt ist.

10. Elektronischer Sensor-Ein/Aus-Schalter nach Anspruch 9, gekennzeichnet durch eine Logik (11) folgender Ausbildung :

ein Flip-Flop (21), das mit seinem Setzeingang (S) an den Ausgang des monostabilen Multivibrators (13) und mit seinem Rücksetzeingang (R) über einen Inverter (20) an den Ausgang des Spannungs-Nulldurchgangsdetektors (10) angekoppelt ist,

ein erstes UND-Gatter (22), das mit einem Eingang an einen komplementären Ausgang ($\overline{Q}$) des Flip-Flops (21) und mit einem weiteren Eingang an den Ausgang des Spannungs-Nulldurchgangsdetektors (10) angekoppelt ist,

ein ODER-Gatter (23), das mit einem Eingang an den Ausgang des ersten UND-Gatters (22) und mit einem weiteren Eingang an den Ausgang des monostabilen Multivibrators (13) angekoppelt ist,

und ein zweites UND-Gatter (24), das mit einem Eingang an den Ausgang des ODER-Gatters (23) mit einem weiteren Eingang an den Sensor (14) und mit seinem Ausgang an die Steuerelektrode (G) des steuerbaren Halbleiterschalters (5) angekoppelt ist,

11. Elektronischer Sensor-Ein/Aus-Schalter nach Anspruch 10, dadurch gekennzeichnet, daß der Sensor (14) über einen Vorverstärker (15) und ein Verzögerungsglied (16) auf den Steuereingang eines Ein/Aus-Flip-Flops (17) gekoppelt ist, dessen Ausgang an den weiteren Eingang des zweiten UND-Gatters (24) der Logik (11) geschaltet ist.

12. Elektronischer Sensor-Ein/Aus-Schalter nach Anspruch 11, dadurch gekennzeichnet, daß die Logik (11) weiterhin einen vom Ausgang des Ein/Aus-Flip-Flops (17) angesteuerten monostabilen Multivibrator (25) sowie ein zweites ODER-Gatters (26) enthält, und daß der Ausgang des monostabilen Multivibrators (25) an einem Eingang des zweiten ODER-Gatters (26), der Ausgang des zweiten UND-Gatters (24) an einen weiteren Eingang des zweiten ODER-Gatters (26) und der Ausgang des zweiten ODER-Gatters (26) an die Steuerelektrode (G) des steuerbaren Halbleiterschalters (5) angekoppelt ist.

13. Elektronischer Sensor-Ein/Aus-Schalter nach einem der Ansprüche 1 bis 4 und 6, dadurch gekennzeichnet, daß die Steuerschaltung (10, 110)

einen Spannungs-Nulldurchgangsdetektor (10), welcher bei gesperrtem steuerbaren Halbleiterschalter (5) und damit ausgeschalteter Last (L) als Funktion der Nulldurchgänge der Ausgangswechselspannung $(U_T)$ ein impulsförmiges Ausgangssignal $(U_U)$ abgibt,

und eine durch ein Einschaltsignal vom Sensor (14) und vom impulsförmigen Ausgangssignal $(U_U)$ des Spannungs-Nulldurchgangsdetektors (10) wirksam geschaltete Logik (110) zur Einspeisung des impulsförmigen Ausgangssignals des Spannungs-Nulldurchgangsdetektors (10) in die Steuerelektrode (G) des steuerbaren Halbleiterschalters (5), aufweist,

und daß die Logik (110)

ein UND-Gatter (111), das mit einem Eingang an den Ausgang des Spannungs-Nulldurchgangsdetektors (10) und mit einem weiteren Eingang an den Sensor (14) angekoppelt ist,

einen Inverter (112), der mit seinem Eingang an den Sensor (14) angekoppelt ist,

und ein Flip-Flop (113), das mit einem Setzeingang (S) an den Ausgang des UND-Gatters (111), mit einem Rücksetzeingang (R) an den Ausgang des Inverters (112) und mit einem durch ein Signal an seinem Setzeingang (S) wirksam geschalteten Ausgang (Q) an die Steuerelektrode (G) des steuerbaren Halbleiterschalters (5) angekoppelt ist, umfaßt.

## Claims

1. An electronic sensor on/off switch for a load connected to an alternating voltage network, in particular a two-wire line, having a controllable semiconductor switch, in particular a triac, arranged in series with the load and controlled by a sensor contact switch to connect and disconnect the load, and having a current supply circuit which, when the controllable semiconductor switch is blocked, enables a storage capacitor to be charged via a rectifier from the alternating output voltage supplied from the alternating voltage network, characterised by a control circuit (10, 11, 12 ; 10, 110), which when in the conductive state connects the load (L) at the zero passages of a currently flowing load current $(i_L)$, the controllable semiconductor switch (5) being driven by means of a signal which retains the semiconductor switch in the conductive state, and/or when in the blocked state with the load (L) disconnected connects the load (L) at a zero passage of the alternating output voltage $(U_T)$ which then occurs at the semiconductor switch circuit, the controllable semiconductor switch being driven by a signal which switches it into the conductive state, and by a current supply circuit (9) for the control circuit (10, 11, 12 ; 10, 11) having a current converter (6) which possesses a primary winding (7) and a secondary winding (8) and is operated in saturation, its primary winding (7) being arranged in series with the controllable semiconductor switch (5) and to whose secondary winding (8) a first rectifier $(D_{10}$ to $D_{13})$ is coupled, where at the output of this rectifier $(D_{10}$ to $D_{13})$, in the case of the conductive controllable semiconductor switch (5), an operating voltage $(-U_S)$ can be tapped relative to a reference potential point of the alternating output voltage $(U_T)$, and having a branch consisting of a series connection of a storage capacitor $(C_S)$ and a second rectifier $(D_1)$ arranged parallel to the series connection consisting of the primary winding (7) of the current converter (6) and the controllable semi-conductor switch (5) and wherein in the blocked state of the controllable semiconductor switch (5) the operating voltage $(-U_S)$ can be tapped at the storage capacitor $(C_S)$ loaded from the alternating output voltage $(U_T)$.

2. An electronic sensor on/off switch as claimed in Claim 1, characterised in that the first rectifier $(D_{10}$ to $D_{13})$ is a full-wave rectifier.

3. An electronic sensor on/off switch as claimed in Claims 1 and 2, characterised in that a Zener diode (ZD) is connected parallel to the series connection consisting of the storage capacitor $(C_S)$ and the second rectifier $(D_1)$.

4. An electronic sensor on/off switch as claimed in one of Claims 1 to 3, characterised in that a dropper resistor $(Z_V)$ is connected preceding the branch consisting of the storage capacitor $(C_S)$ and the second rectifier $(D_1)$.

5. An electronic sensor on/off switch as claimed in one of Claims 1 to 4, characterised in that the control circuit (10, 11, 12) comprises

a voltage zero passage detector (10) which emits a pulse-shaped output signal $(U_T)$ as a function of the zero passages of the alternating output voltage ($U_T$) when the controllable semiconductor switch (5) is blocked and the load (L) is therefore disconnected, and comprises a logic circuit (11), which is switched to be effective by means of a starting signal from the sensor (14) and the pulse-shaped output signal ($U_U$) of the voltage zero passage detector (10), for feeding the pulse-shaped output signal of the voltage zero passage detector (10) into a control electrode (G) of the controllable semiconductor switch (5) and comprises a current zero passage detector (12) coupled to a secondary winding (8) of the current converter (6) and which transfers the secondary voltage ($U_{SEK}$) of the current converter (6) into a pulse-shaped output signal ($U_i'$), where the logic circuit (11) decouples the voltage zero passage detector (10) from the control electrode (G) while the controllable semiconductor switch (5) is conductive and couples the pulse-shaped output signal ($U_i'$) of the current zero passage detector (12) to the control electrode (G) of the controllable semiconductor switch (5).

6. An electronic sensor on/off switch as claimed in one of Claims 1 to 5, characterised by a voltage zero passage detector (10) of the following construction :

a first transistor ($T_{10}$) which has its emitter connected to the reference potential point ($O_S$) of the alternating output voltage ($U_T$), and its collector connected to the operating voltage (-$U_S$) by an operating resistor ($R_{12}$) and its base connected to the tap of a voltage divider ($R_{10}$, $R_2$) arranged at the alternating output voltage ($U_T$),

a second transistor ($T_{11}$) which has its emitter connected to the tap of the voltage divider ($R_{10}$, $R_2$), its collector to the operating voltage (-$U_S$) by means of the operating resistor ($R_{12}$) and its base connected to the reference potential point ($O_S$) of the alternating output voltage ($U_T$),

and a third transistor ($T_{12}$) which has its emitter connected to the reference potential point ($O_S$) of the alternating output voltage ($U_T$), its collector to the operating voltage (-$U_S$) by a further operating resistor ($R_{13}$) and its base connected to the connection point of the collectors of the first and second transistors ($T_{10}$ ; $T_{11}$) and the operating resistor ($R_{12}$) thereof, where the voltage divider ($R_{10}$, $R_2$) is so dimensioned that the first and second transistor ($T_{10}$, $T_{11}$) are switched through in the region of the zero passage of the alternating output voltage ($U_T$) in the case of a predetermined negative or positive value, as the case may be, and where the pulse-shaped output signal ($U_U$) can be tapped between the reference potential point ($O_S$) of the alternating output voltage ($U_T$) and the collector of the third transistor ($T_{12}$).

7. An electronic sensor on/off switch as claimed in one of Claims 1 to 6, characterised by a current zero passage detector (12) of the following construction :

a first input transistor ($T_{20}$) whose base forms an input terminal (30) and is connected to the operating voltage (-$U_S$) by a resistor ($R_{20}$), whose emitter is connected to the reference potential

point ($O_S$) of the alternating output voltage ($U_T$) and whose collector is connected to the operating voltage (-$U_S$) by an operating resistor ($R_{21}$),

a second input transistor ($T_{21}$), whose base forms a further input terminal (31) and is connected to the operating voltage (-$U_S$) by a resistor ($R_{22}$), whose emitter is connected to the reference potential point ($O_S$) of the alternating output voltage ($U_T$) and whose collector is connected to the operating voltage (-$U_S$) by an operating resistor ($R_{24}$),

and each of a pair of output transistors ($T_{22}$ and $T_{23}$) connected preceding the first or the second input transistors ($T_{20}$ and $T_{21}$) and each of whose base is connected to the collector of the corresponding input transistors ($T_{20}$ and $T_{21}$), each of whose emitter is connected to the reference potential point ($O_S$) of the alternating output voltage ($U_T$) and each of whose collectors are commonly connected to the operating voltage (-$U_S$) by an operating resistor ($R_{23}$), where the pulse-shaped output signal ($U_i'$) can be tapped between the reference potential point (-$O_S$) of the alternating output voltage ($U_T$) and the collectors of the output transistors ($T_{22}$, $T_{23}$).

8. An electronic sensor on/off switch as claimed in one of Claims 5 to 7, characterised in that the current zero passage detector (12) has its input terminals (30, 31) respectively coupled to the secondary winding (8) of the current converter (6) by means of a diode ($D_{20}$, $D_{21}$).

9. An electronic sensor on/off switch as claimed in one of Claims 5 to 8, characterised in that the current zero passage detector (12) is coupled to the logic circuit (11) by means of a mono-stable multi-vibrator (13) in order to adjust a predetermined pulse duration of its pulse-shaped output signal ($U_i'$).

10. An electronic sensor on/off switch as claimed in Claim 9, characterised by a logic circuit (11) of the following construction :

a flip-flop (21) which has its setting input (S) connected to the output of the monostable multivibrator (13) and its re-setting input (R) via an inverter (20) to the output of the voltage zero passage detector (10),

a first AND-gate (22) which has one input connected to a complementary output ($\overline{Q}$) of the flip-flop (21) and has a further input connected to the output of the voltage zero passage detector (10),

an OR-gate (23) which has one input connected to the output of the first AND-gate (22) and has a further input coupled to the output of the mono-stable multivibrator (13),

and a second AND-gate (24) which has one input connected to the output of the OR-gate (23) and a further input connected to the sensor (14) and its output connected to the control electrode (G) of the controllable semiconductor switch (5).

11. An electronic sensor on/off switch as claimed in Claim 10, characterised in that the sensor (14) is coupled to the control input of an on/off flip-flop (17) by a preamplifier (15) and a delay element (16), the output of which flip-flop is connected to the further input of the second AND-gate (24) of the logic circuit (11).

12. An electronic sensor on/off switch as claimed in Claim 11, characterised in that the logic circuit (11) further comprises both a monostable multivibrator (25), controlled by the output of the on/off flip-flop (17), and a second OR-gate (26), and that the output of the monostable multivibrator (25) is coupled to an input of the second OR-gate (26), the output of the second AND-gate (24) is coupled to a further input of the second OR-gate (26) and the output of the second OR-gate (26) is coupled to the control electrode (G) of the controllable semiconductor switch (5).

13. An electronic sensor on/off switch as claimed in one of claims 1 to 4 and 6, characterised in that the control circuit (10, 110) comprises

a voltage zero passage detector (10) which when the controllable semiconductor switch (5) is blocked and the load (L) is therefore disconnected emits a pulse-shaped output signal ($U_U$) as a function of the zero passages of the alternating output voltage ($U_T$), and comprises a logic circuit (110) switched so as to be effective by a starting signal from the sensor (14) and the pulse-shaped output signal ($U_U$), in order to feed the pulse-shaped output signal of the voltage zero passage detector (10) into the control electrode (G) of the controllable semiconductor switch (5),

and that the logic (110) comprises

an AND-gate (11) which has one input connected to the output of the voltage zero passage detector (10) and a further input to the sensor (14),

and comprises an inverter (112) which has its input connected to the sensor (14) and

comprises a flip-flop (113) which has its setting input (S) connected to the output of the AND-gate (111), its re-setting input (R) to the output of the inverter (112) and has an output (Q) switched so as to be effective by a signal at its setting input (S), connected to the control electrode (G) of the controllable semiconductor switch (5).


## Revendications

1. Commutateur électronique marche-arrêt à effleurement pour une charge branchée sur un réseau de tension alternative réalisé en particulier sous la forme d'un conducteur bifilaire, avec un commutateur à semiconducteurs contrôlable, en particulier un Triac, monté en série avec la charge, et qui peut être attaqué par l'intermédiaire d'un détecteur réalisé sous la forme d'un commutateur de proximité pour le branchement et le débranchement de la charge, avec un circuit d'alimentation en courant qui comporte un condensateur de mémorisation susceptible d'être chargé, lorsque le commutateur à semiconducteurs contrôlable est bloqué, par l'intermédiaire d'un redresseur à partir de la tension alternative de sortie fournie par le réseau de tension alternative, caractérisé par un circuit de commande (10, 11, 12 ; 10, 110) à l'aide duquel le commutateur à semiconducteurs contrôlable (5) est susceptible d'être commandé, lorsqu'il est dans son état conducteur, et, par suite, lorsque la charge (L) est branchée, et aux passages par la valeur nulle d'un courant de charge ($i_L$) qui passe alors, par un signal qui le maintient dans son état conducteur, et/ou lorsqu'il est dans son état bloqué et, par suite, lorsque la charge (L) est débranchée, pour le branchement de la charge (L) au passage de la valeur nulle de la tension alternative de sortie ($U_T$) présente alors au niveau du circuit du commutateur à semiconducteurs, par un signal qui le commande dans l'état conducteur, et par un circuit d'alimentation en courant (9) pour le circuit de commande (10, 11, 12 ; 10, 110) avec un transformateur de courant (6) opérant dans la plage de saturation et comportant un enroulement primaire (7) et un enroulement secondaire (8), et dont l'enroulement primaire (7) est monté en série avec le commutateur à semiconducteurs contrôlable (5) et à l'enroulement secondaire (8) duquel est relié un premier redresseur ($D_{10}$ à $D_{13}$), une tension de fonctionnement ($-U_S$) pouvant, relativement à un point de potentiel de référence ($O_S$) qui est en même temps le point de potentiel de référence de la tension alternative de sortie ($U_T$), être prélevée à la sortie de ce redresseur ($D_{10}$ à $D_{13}$) lorsque le commutateur à semiconducteurs contrôlable (5) est conducteur, et avec une branche parallèle au circuit série constitué par l'enroulement primaire (7) du transformateur de courant (6) et par le commutateur à semiconducteurs contrôlable (5), et formée par le circuit série d'un commutateur de mémorisation ($C_S$) et d'un second redresseur ($D_1$), dans laquelle, à l'état fermé du commutateur à semiconducteurs contrôlable (5), la tension de fonctionnement ($-U_S$) peut être prélevée au niveau du condensateur de mémorisation ($C_S$) chargé à partir de la tension alternative de sortie ($U_T$).

2. Commutateur électronique marche-arrêt à effleurement selon la revendication 1, caractérisé par le fait que le premier redresseur ($D_{10}$ à $D_{13}$) est un redresseur à deux alternances.

3. Commutateur électronique marche-arrêt à effleurement selon la revendication 1 ou 2, caractérisé par le fait qu'en parallèle sur le circuit série constitué par le condensateur de mémorisation ($C_S$) et par le second redresseur ($D_1$) est montée une diode Zener (ZD).

4. Commutateur électronique marche-arrêt à effleurement selon l'une des revendications 1 à 3, caractérisé par le fait qu'une résistance amont ($Z_V$) est montée en série avec la branche constituée par le condensateur de mémorisation ($C_S$) et par le second redresseur ($D_1$).

5. Commutateur électronique marche-arrêt à effleurement selon l'une des revendications 1 à 4, caractérisé par le fait que le circuit de commande (10, 11, 12) comporte

un détecteur de passage de la tension par la valeur nulle (10), qui, lorsque le commutateur à semiconducteurs contrôlable (5) est bloqué et que de ce fait la charge (L) est débranchée, émet, comme fonction des passages par la valeur nulle de la tension alternative de sortie ($U_T$), un signal de sortie ($U_U$) de forme impulsionnelle, un circuit logique (11) commuté dans sa position efficace par le signal de sortie ($U_U$) de forme impulsionnelle du détecteur de passage de la tension par la valeur nulle (10) en vue de la mémorisation du signal de sortie de forme impulsionnelle du détecteur de passage de la tension par la valeur nulle (10) dans une électrode de commande (G) du commutateur à semiconducteurs contrôlable (5), et un détecteur de passage du courant par la valeur nulle (12), relié à un enroulement secondaire (8) du transformateur de courant (6), lequel détecteur de passage du courant par la valeur nulle transforme la tension secondaire ($U_{SEC}$) du convertisseur de courant (6) en un signal de sortie ($U_I'$) de forme impulsionnelle, la réalisation étant telle que le circuit logique (11) débranche le détecteur du passage de la tension par la valeur nulle (10) de l'électrode de commande (G) du commutateur à semiconducteurs contrôlable (5), lorsque ce commutateur est conducteur, et applique le signal de sortie de forme impulsionnelle ($U_I'$) du détecteur de passage du courant par la valeur nulle (12) à l'électrode de commande (G) du commutateur à semiconducteurs contrôlable (5).

6. Commutateur électronique marche-arrêt à effleurement selon l'une des revendications 1 à 5, caractérisé par un détecteur de passage de la tension par la valeur nulle (10) de constitution suivante :

un premier transistor ($T_{10}$) qui est relié par son émetteur au point de potentiel de référence ($O_S$) de la tension alternative de sortie ($U_T$) dont le collecteur est relié, par l'intermédiaire d'une résistance de charge ($R_{12}$) à la tension de fonctionnement ($-U_S$) et dont la base est reliée à la prise d'un diviseur de tension ($R_{10}$, $R_2$), auquel est appliquée la tension alternative de sortie ($U_T$),

un second transistor ($T_{11}$) dont l'émetteur est relié à la prise du diviseur de tension ($R_{10}$, $R_2$), dont le collecteur est relié, par l'intermédiaire de la résistance de charge ($R_{12}$), à la tension de fonctionnement ($-U_S$) et dont la base est reliée au point de potentiel de référence ($O_S$) de la tension alternative de sortie ($U_T$),

et un troisième transistor ($T_{12}$) dont l'émetteur est relié au point de potentiel de référence ($O_S$) de la tension alternative de sortie ($U_T$), dont le collecteur est relié, par l'intermédiaire d'une autre résistance de charge ($R_{13}$), à la tension de fonctionnement ($-U_S$) et dont la base est reliée au point de liaison des collecteurs du premier et du second transistors ($T_{10}$, $T_{11}$) et leur résistance de charge ($R_{12}$), la réalisation étant telle que le diviseur de tension ($R_{10}$, $R_2$) est dimensionné de telle façon que le premier et le second transistors ($T_{10}$, $T_{11}$) sont commutés dans leur état passant, pour une valeur négative ou positive prédéterminée dans le voisinage du passage par la valeur nulle de la tension alternative de sortie ($U_T$) alors que le signal de sortie ($U_U$) de forme impulsionnelle est susceptible d'être prélevé entre le point de potentiel de référence ($O_S$) de la tension

alternative de sortie ($U_T$) et le collecteur du troisième transistor ($T_{12}$).

7. Commutateur électronique marche-arrêt à effleurement, selon l'une des revendications 1 à 6, caractérisé par un détecteur de passage du courant par la valeur nulle (12) ayant la constitution suivante :

un premier transistor d'entrée ($T_{20}$) dont la base constitue une borne d'entrée (30) et est reliée par l'intermédiaire d'une résistance ($R_{20}$) à la tension de fonctionnement ($-U_S$), dont l'émetteur est relié au point de potentiel de référence ($O_S$) de la tension alternative de sortie ($U_T$) et dont le collecteur est relié, par l'intermédiaire d'une résistance de charge ($R_{21}$), à la tension de fonctionnement ($-U_S$),

un second transistor d'entrée ($T_{21}$) dont la base forme une autre borne d'entrée (31) et est reliée par l'intermédiaire d'une résistance ($R_{22}$) à la tension de fonctionnement ($-U_S$), dont l'émetteur est relié au point de potentiel de référence ($O_S$) de la tension alternative de sortie ($U_T$) et dont le collecteur est relié par l'intermédiaire d'une résistance de charge ($R_{24}$), à la tension de fonctionnement ($-U_S$),

et respectivement un transistor de sortie ($T_{22}$, $T_{23}$) monté en aval du premier et du second transistors d'entrée ($T_{20}$, $T_{21}$), et dont les bases sont reliées au collecteur du transistor d'entrée correspondant ($T_{20}$ ou $T_{21}$), dont les émetteurs sont reliés au point de potentiel de référence ($O_S$) de la tension alternative de sortie ($U_T$) et dont les collecteurs sont reliés, en commun, par l'intermédiaire d'une résistance de charge ($R_{23}$), à la tension de fonctionnement ($-U_S$), la réalisation étant telle que le signal de sortie ($U_I'$) de forme impulsionnelle est susceptible d'être prélevé entre le point de potentiel de référence ($-O_S$) de la tension alternative de sortie ($U_T$) et les collecteurs des transistors de sortie ($T_{22}$, $T_{23}$).

8. Commutateur électronique marche-arrêt à effleurement selon l'une des revendications 5 à 7, caractérisé par le fait que le détecteur du passage du courant par la valeur nulle (12) est relié, par ses bornes d'entrée (30, 31), et respectivement par une diode ($D_{20}$, $D_{21}$), à l'enroulement secondaire (8) du transformateur de courant (6).

9. Commutateur électronique marche-arrêt à effleurement selon l'une des revendications 5 à 8, caractérisé par le fait que le détecteur du passage du courant par la valeur nulle (12) est relié, pour régler une durée d'impulsion prédéterminée de son signal de sortie ($U_I'$) de forme impulsionnelle, au circuit logique (11), par l'intermédiaire d'un multivibrateur monostable (13).

10. Commutateur électronique marche-arrêt à effleurement selon la revendication 9, caractérisé par un circuit logique (11) ayant la constitution suivante :

un multivibrateur bistable (21) qui est relié, par son entrée d'activation (S), à la sortie du multivibrateur monostable (13) et dont l'entrée de remise à l'état initial (R) est reliée, par l'intermédiaire d'un inverseur (20), à la sortie du détecteur du passage de la tension par la valeur nulle (10),

une première porte ET (22) qui est reliée, par une entrée, à une sortie complémentaire (Q̄) du multivibrateur bistable (21) et, avec une autre entrée, à la sortie du détecteur du passage de la tension par la valeur nulle (10),

une porte OU (23) qui rest reliée, par une entrée, à la sortie de la première porte ET (22) et, par une autre entrée, à la sortie du multivibrateur monostable (13),

et une seconde porte ET (24) qui est reliée, par une entrée, à la sortie de la porte OU (23), par une autre entrée au détecteur (14), et par sa sortie à l'électrode de commande (G) du commutateur à semi-conducteur contrôlable (5).

11. Commutateur électronique marche-arrêt à effleurement selon la revendication 10, caractérisé par le fait que le détecteur (14) est relié, par l'intermédiaire d'un préamplificateur (15) et d'un dispositif à retard (16), à l'entrée de commande d'un multivibrateur bistable marche-arrêt (17) dont la sortie est reliée à la seconde entrée de la seconde porte ET (24) du circuit logique (11).

12. Commutateur électronique marche-arrêt à effleurement selon la revendication 11, caractérisé par le fait que le circuit logique (11) comporte, en outre, un multivibrateur monostable (25) qui est commandé par la sortie du multivibrateur bistable marche-arrêt (17), de même qu'une seconde porte OU (26) et que la sortie du multivibrateur monostable (25) est reliée à une entrée de la seconde porte OU (26), alors que la sortie de la seconde porte ET (24) est reliée à une autre entrée de la seconde porte OU (26) et que la sortie de la seconde porte OU (26) est reliée à l'électrode de commande (G) du commutateur à semiconducteurs contrôlable (5).

13. Commutateur électronique marche-arrêt à effleurement selon l'une des revendications 1 à 4 et 6, caractérisé par le fait que le circuit de commande (10, 110) comporte

un détecteur du passage de la tension par la valeur nulle (10) qui, lorsque le commutateur à semiconducteurs contrôlable (5) est bloqué et que de ce fait la charge (L) est débranchée, émet, comme fonction des passages par la valeur nulle de la tension alternative de sortie ($U_T$), un signal de sortie ($U_U$) de forme impulsionnelle,

et un circuit logique (110) commuté dans son état efficace par un signal de branchement du détecteur (14) et du signal de sortie ($U_U$) de forme impulsionnelle du détecteur de passage de la tension par la valeur nulle (10), en vue de la mémorisation du signal de sortie, de forme impulsionnelle, du détecteur de passage de la tension par la valeur nulle (10) dans l'électrode de commande (G) du commutateur à semiconducteurs contrôlable (15),

et que le circuit logique (110) comporte

une porte ET (111) qui est reliée, par une entrée, à la sortie du détecteur de passage de la tension par la valeur nulle (10) et, par une autre entrée, au détecteur (14),

un inverseur (112) qui est relié, par son entrée, au détecteur (14),

et un multivibrateur bistable (113) qui est relié par son entrée d'activation (S) à la sortie de la porte ET (111), par son entrée de remise à l'état initial (R) à la sortie de l'inverseur (112), et par une sortie (Q) commutée dans la position efficace par un signal appliqué à son entrée d'activation (S), à l'électrode de commande (G) du commutateur à semiconducteurs contrôlable (5).

FIG 1

FIG 2A $0_S$ $U_T$

FIG 2B $0_S$ $U_U$ $0_S$

FIG 2C $U_{SP}$

EIN AUS

FIG 2D $0_S$ $U_{GATE}$

FIG 2E $0_S$ $i_L$

FIG 2F $0$ $U_{SEK}$

FIG 2G $0_S$ $U_I$ $0_S$

FIG 2H $0_S$ $U_{RSFF}$

t

# FIG 3

# FIG 4

# FIG 5

# FIG 6

FIG 7A

FIG 7B

FIG 7C

FIG 7D

FIG 7E

# FIG 8

0019812